# EUROPEAN PATENT APPLICATION

(11) **EP 1 850 386 A1**
(43) Date of publication of application: **31.10.2007**
(21) Application number: 07251523.2
(22) Date of filing: 05.04.2007
(51) Int. Cl.: H01L 27/12, H01L 21/77, G02F 1/1362, H01L 29/49, H01L 29/786

(54) **Electro-optical device, electronic apparatus, and method of manufacturing electro-optical device**

(30) Priority: 26.04.2006 JP 2006121641
(71) Applicant: Epson Imaging Devices Corporation, Azumino-shi Nagano 399-8285 (JP)
(72) Inventor: Sato, Takasi c/o Epson Imaging Devices Corporation, Nagano 399-8285 (JP); Morita, Satoshi c/o Epson Imaging Devices Corp., Azumino-shi, Nagano 399-8285 (JP)
(74) Representative: Cloughley, Peter Andrew

(57) **Abstract**

An electro-optical device includes a thin-film transistor that has a gate electrode, a gate insulating layer, and a semiconductor layer laminated in each of a plurality of pixel regions on an element substrate, a pixel electrode that is electrically connected to a drain region of the thin-film transistor, and a storage capacitor that has a lower electrode and an upper electrode facing each other with the gate insulating layer interposed therebetween. In the thin-film transistor, the gate electrode, the gate insulating layer, and the semiconductor layer are laminated sequentially in that order. The gate insulating layer includes a lower gate insulating layer having one or a plurality of insulating films, and an upper gate insulating layer having one or a plurality of insulating films. The lower gate insulating layer is formed to have a thickness sufficient to reduce parasitic capacitance of the thin-film transistor, and a portion of the lower gate insulating layer where the lower electrode and the upper electrode overlap each other is removed.

## Description

The present invention relates to an electro-optical device that includes a thin-film transistor and a storage capacitor on an element substrate, to an electronic apparatus, and to a method of manufacturing an electro-optical device.

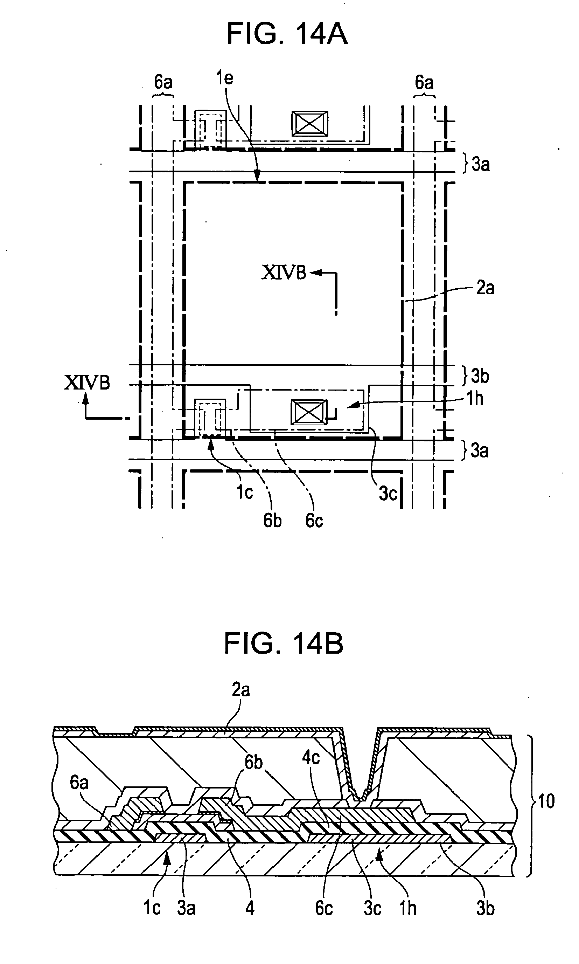

Among various electro-optical devices, an active matrix liquid crystal device includes, for example, an element substrate 10 shown in Figs. 14A and 14B and a counter substrate (not shown) with liquid crystal interposed therebetween. On the element substrate 10, in each of a plurality of pixel regions 1e that are arranged to correspond intersections of gate lines 3a (scanning lines) and source lines 6a (data lines), a pixel-switching thin-film transistor 1c, and a pixel electrode 2a electrically connected to a drain region of the thin-film transistor 1c are formed. For each pixel, the alignment of liquid crystal is controlled by an image signal that is applied from the source line 6a to the pixel electrode 2a through the thin-film transistor 1c. Further, in the pixel region 1e, a storage capacitor 1h, that has an extended portion of a drain electrode 6b for driving liquid crystal as an upper electrode 6c, is formed. In many cases, the storage capacitor 1h uses a gate insulating layer 4 of the thin-film transistor 1c as a dielectric layer 4c. Here, if the value of capacitance per unit area of the storage capacitor 1h per unit area is increased, a charge holding property is improved. In addition, if the value of capacitance per unit area of the storage capacitor 1h is increased, a space can be reduced, and a pixel aperture ratio can be increased.

In Japanese Patent No. 2584290, a method of forming a bottom-gate-type thin-film transistor having a gate electrode, a gate insulating layer, and a semiconductor layer sequentially laminated in that order is suggested.
Specifically, in this method, the gate insulating layer is formed, and then an island-shaped semiconductor layer is formed on the gate insulating layer. Next, a portion of the gate insulating layer that overlaps a lower electrode of the storage capacitor is etched to a midstream position in a depthwise direction, and a portion that is reduced in thickness by etching is used as a dielectric layer of the storage capacitor.

Further, in Japanese Patent No. 3106566, a method of forming a top-gate-type thin-film transistor having a semiconductor layer, a gate insulating layer, and a gate electrode sequentially laminated in that order is suggested. Specifically, in this method, a laminate of a first insulating film formed of a silicon oxide film by thermal oxidization on a semiconductor layer and a second insulating film formed of a silicon nitride film by a CVD method is formed as a gate insulating layer. Next, a region of the gate insulating layer that overlaps a channel region is covered with a resist mask, the second insulating film is removed by etching, and a portion of the gate insulating layer that is reduced in thickness is used as a dielectric layer of a storage capacitor.

However, like the technology disclosed in Japanese Patent No. 2584290, when the gate insulating layer is reduced in thickness by etching to form the dielectric layer of the storage capacitor, a variation in thickness upon film-forming and a variation in removal amount of the gate insulating layer upon etching may occur. Accordingly, a variation in capacitance of the storage capacitor may easily occur.

Further, similarly to the technology disclosed in Japanese Patent No. 3106566 , if the region of the gate insulating layer that overlaps the channel region is covered with the resist mask and then the second insulating film is etched, an interface of the gate insulating layer and the gate electrode may be contaminated with the resist.

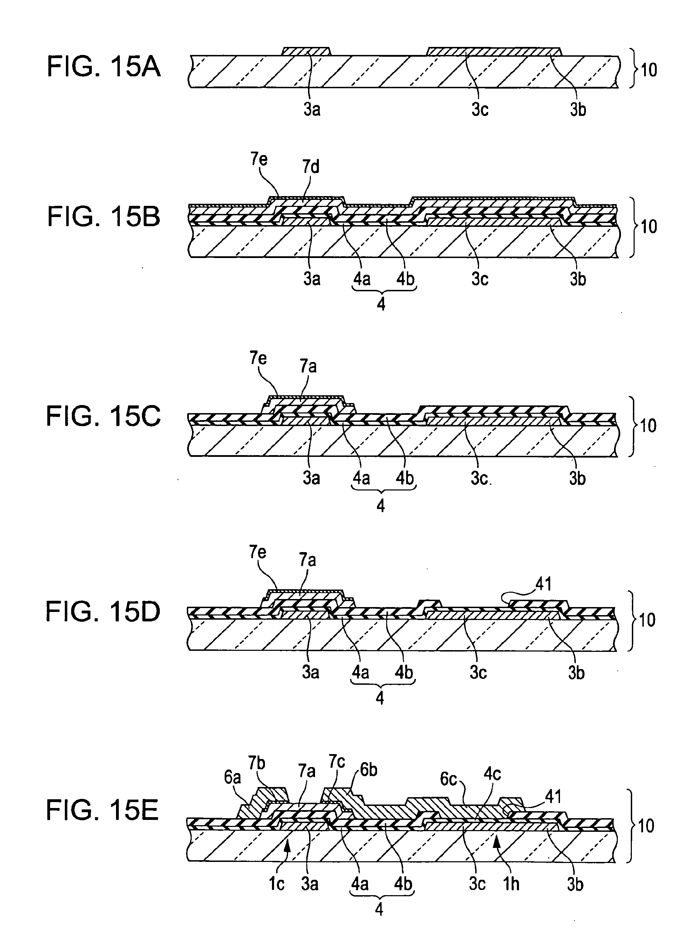

As described below with reference to Figs. 15A to 15D, the inventors have proposed to apply the technology described in Japanese Patent No. 2584290 to an element substrate including a bottom-gate-type thin-film transistor described with reference to Figs. 14A and 14B. With this configuration, as described below with reference to Figs. 15A to 15D, the interface of the gate insulating layer and the gate electrode can be prevented from being contaminated with the resist. However, similarly to the technology disclosed in Japanese Patent No. 3106566, when an overlying second insulating film of the first insulating film and the second insulating film constituting the gate insulating layer is removed by etching, the first insulating film may be damaged upon etching of the second insulating film, and a withstand voltage of the storage capacitor may be decreased.
Figs. 15A to 15D are cross-sectional views of an element substrate 10 including a bottom-gate-type thin-film transistor 1c showing a case where the technology described in Japanese Patent No. 3106566 is applied to the manufacture thereof, as shown in Figs. 14A and 14B. The above-described technology is just for reference, not described as the prior art. In a manufacturing method shown in Figs. 15A to 15D, first, as shown in Fig. 15A, a gate line 3a (gate electrode) and a lower electrode 3c (a portion of a capacitor line 3b) are formed together. Then, as shown in Fig. 15B, a lower gate insulating layer 4a as a lower layer of a gate insulating layer 4 and an upper gate insulating layer 4b as an upper layer of the gate insulating layer 4 are formed. Next, an intrinsic amorphous silicon film 7d as an active layer, and an n+ silicon film 7e as an ohmic contact layer are sequentially formed. Then, etching is performed to pattern the semiconductor layer 7a as the active layer and the n+ silicon film 7e in an island shape, as shown in Fig. 15C. Next, as shown in Fig. 15D, a portion of the gate insulating layer 4 that overlaps the lower electrode 3c is etched, and the upper gate insulating layer 4b is removed to form an opening 41. Next, a conductive film is formed and etched to form a source electrode (source line 6a) and a drain electrode 6b. Subsequently, the n+ silicon film 7e is etched to form ohmic contact layers 7b and 7c. As a result, the thin-film transistor 1c is formed. Further, the storage capacitor 1h that has the lower gate insulating layer 4a as the dielectric layer 4c and an extended portion of the drain electrode 6b as the upper electrode 6c is formed.

According to such a manufacturing method, the interface of the gate insulating layer 4 and the gate electrode (gate line 3a) and the interface of the gate insulating layer 4 and the semiconductor layer 7a can be prevented from being contaminated with the resist. However, when a semiconductor film 7a is patterned by dry etching at the step shown in Fig. 15C and when the upper gate insulating layer 4b is removed by dry etching at the step shown in Fig. 15D, the lower gate insulating layer 4a may be damaged by static electricity or plasma upon dry etching, and defects may occur in the lower gate insulating layer 4a. In addition, when the upper gate insulating layer 4b is removed by wet etching at the step shown in Fig. 150, pin holes may occur in weak portions of the lower gate insulating layer 4a. As a result, a withstand voltage of the storage capacitor 1h may be decreased.

An advantage of some aspects of the invention is that it provides an electro-optical device capable of suppressing a variation in capacitance of a storage capacitor and lowering of a withstand voltage in a storage capacitor, even though a portion of a gate insulating layer that is partially reduced in thickness is used as a dielectric layer of a storage capacitor, an electronic apparatus, and a method of manufacturing an electro-optical device.

According to an aspect of the invention, an electro-optical device includes a thin-film transistor that has a gate electrode, a gate insulating layer, and a semiconductor layer laminated in each of a plurality of pixel regions on an element substrate, a pixel electrode that is electrically connected to preferably a drain region of the thin-film transistor, and a storage capacitor that has a lower electrode and an upper electrode facing each other with the gate insulating layer interposed therebetween. In the thin-film transistor, the gate electrode, the gate insulating layer, and the semiconductor layer are laminated sequentially in that order. The gate insulating layer includes a lower gate insulating layer having one or a plurality of insulating films, and an upper gate insulating layer having one or a plurality of insulating films. The lower gate insulating layer is preferably formed to have a thickness sufficient to reduce parasitic capacitance of the thin-film transistor, and a portion of the lower gate insulating layer where the lower electrode and the upper electrode overlap each other is removed.

According to another aspect of the invention, there is provided a method of manufacturing an electro-optical device that includes a thin-film transistor having a gate electrode, a gate insulating layer, and a semiconductor layer laminated in each of a plurality of pixel regions on an element substrate, a pixel electrode electrically connected to preferably a drain region of the thin-film transistor, and a storage capacitor having a lower electrode and an upper electrode facing each other with the gate insulating layer interposed therebetween. The method includes forming the gate electrode and the lower electrode together, forming the gate insulating layer, and forming the semiconductor layer. The forming of the gate insulating layer includes forming one or a plurality of insulating films forming a lower layer of the gate insulating layer, preferably to have a thickness sufficient to reduce parasitic capacitance of the thin-film transistor, removing a portion of the insulating film, which overlaps the lower electrode, formed in the forming of the lower gate insulating layer, and forming one or a plurality of insulating films forming an upper layer of the gate insulating layer.

With this configuration, as a thin-film transistor forming a pixel forming region, the bottom-gate-type thin-film transistor that has the gate electrode, the gate insulating layer, and the semiconductor layer is provided. Accordingly, the upper gate insulating layer and the semiconductor layer can be successively formed. Therefore, the interface of the gate insulating layer and the gate electrode and the interface of the gate insulating layer and the semiconductor layer can be prevented from being contaminated with resist. For this reason, reliability of the thin-film transistor can be improved. Further, in a case where a portion of the gate insulating layer that is partially reduced in thickness is used as a dielectric layer of the storage capacitor, the lower gate insulating layer does not remain, and the dielectric layer is formed of only the upper gate insulating layer. Accordingly, it is not necessary to apply the configuration that the gate insulating layer is etched at a midstream position in a depthwise direction. Therefore, a variation in capacitance of the storage capacitor can be prevented from occurring due to a variation in etching depth. In addition, in a case where a portion of the gate insulating layer that is partially reduced in thickness is used as the dielectric layer of the storage capacitor, from the lower gate insulating layer and the upper gate insulating layer, the lower gate insulating layer is removed, and the upper gate insulating layer is used as the dielectric layer of the storage capacitor. With this upper gate insulating layer, since there is no effect of static electricity or plasma when the lower gate insulating layer is partially subject to dry etching, damages or defects of the surface of the upper gate insulating layer can be prevented from occurring. Besides, the upper gate insulating layer is not exposed to an etchant when the lower gate insulating layer is partially subject to wet etching. Accordingly, pin holes do not occur in the upper gate insulating layer. For this reason, a withstand voltage of the storage capacitor can be prevented from being decreased.

The upper gate insulating film may be formed to have a thickness smaller than the lower gate insulating film.

The forming of the upper gate insulating layer and the forming of the semiconductor layer may be successively performed while the element substrate is kept under a vacuum atmosphere. With this configuration, since the surface of the gate insulating layer (the surface of the upper gate insulating layer) can be kept clean, reliability of the thin-film transistor can be improved.

The lower gate insulating layer and the upper gate insulating layer may have a plurality of insulating films or the lower gate insulating layer and the upper gate insulating layer may have one insulating film.

The semiconductor layer is formed of, for example, an amorphous silicon film.

The upper gate insulating layer may be formed of a silicon nitride film. Since the silicon nitride film has dielectric constant larger than the silicon oxide film, higher capacitance can be obtained in the storage capacitor having the same space.

The upper electrode may be a portion that extends from a drain electrode of the thin-film transistor to a region facing the lower electrode.

The upper electrode may be a portion of the pixel electrode facing the lower electrode.

The upper electrode may be a transparent electrode that is electrically connected to a drain electrode of the thin-film transistor. With this configuration, a pixel aperture ratio can be increased, compared with a case where a light-shielding upper electrode is used.

The lower electrode may be formed from a capacitor line that extends in parallel with the gate line. Further, the lower electrode may be formed from a gate line that supplies a gate signal to a previous pixel region adjacent to the pixel region, in which the lower electrode is formed, in a direction crossing the extension direction of the gate line.

The electro-optical device according to the aspect of the invention can be applied to an electronic apparatus, such as a cellular phone or a mobile computer.

Embodiments of the invention will now be described by way of example only with reference to the accompanying drawings, wherein like numbers reference like elements.

Figs. 1A and 1 B are a plan view showing a liquid crystal device (electro-optical device) together constituent elements formed thereon as viewed from a counter substrate, and a cross-sectional view taken along the line IB-IB, respectively.

Fig. 2 is an explanatory view showing the electrical configuration of an element substrate in the liquid crystal device shown in Figs. 1A and 1B.

Figs. 3A and 3B are a plan view of one pixel in the liquid crystal device according to a first embodiment of the invention, and a cross-sectional view of the liquid crystal device taken along the IIIB-IIIB, respectively.

Figs. 4A to 4G are process cross-sectional views showing a manufacturing method of an element substrate that is used in the liquid crystal device shown in Figs. 3A and 3B.

Figs. 5A to 5D are process cross-sectional views showing a manufacturing method of an element substrate that is used in the liquid crystal device shown in Figs. 3A and 3B.

Figs. 6A and 6B are a plan view of one pixel in a liquid crystal device according to a second embodiment of the invention, and a cross-sectional view of the liquid crystal device taken along the line VIB-VIB, respectively.

Figs. 7A to 7G are process cross-sectional views showing a manufacturing method of an element substrate that is used in the liquid crystal device shown in Figs. 6A and 6B.

Figs. 8A and 8B are a plan view of one pixel in a liquid crystal device according to a third embodiment of the invention, and a cross-sectional view of the liquid crystal device taken along the line VIIIB-VIIIB, respectively.

Figs. 9A to 9G are process cross-sectional views showing a manufacturing method of an element substrate that is used in the liquid crystal device shown in Figs. 8A and 8B.

Figs. 10A and 10B are a plan view of one pixel in a liquid crystal device according to a fourth embodiment of the invention, and a cross-sectional view of the liquid crystal device taken along the line XB-XB, respectively.

Figs. 11A to 11G are process cross-sectional views showing a manufacturing method of an element substrate that is used in the liquid crystal device shown in Figs. 10A and 10B.

Figs. 12A and 12B are a plan view of one pixel in a liquid crystal device according to a fifth embodiment of the invention, and a cross-sectional view of the liquid crystal device taken along the line XIIB-XIIB, respectively.

Fig. 13 is an explanatory view showing a case where a liquid crystal device according to an embodiment of the invention is used as display devices of various electronic apparatuses.

Figs. 14A and 14B are a plan view of one pixel in a known liquid crystal device, and a cross-sectional view of the liquid crystal device taken along the line XIVB-XIVB, respectively.

Figs. 15A to 15E are process cross-sectional views showing a manufacturing method of an element substrate that is used in a liquid crystal device according to the related art.

Hereinafter, embodiments of the invention will be described with reference to the drawings. Moreover, the scale of each layer or member has been adjusted to have a recognizable size in the drawings. In the following description, the same parts as those in Figs. 14A to 15E are represented by the same reference numerals in order to make the correspondence clear.

### First Embodiment

### Overall Configuration of Liquid Crystal Device

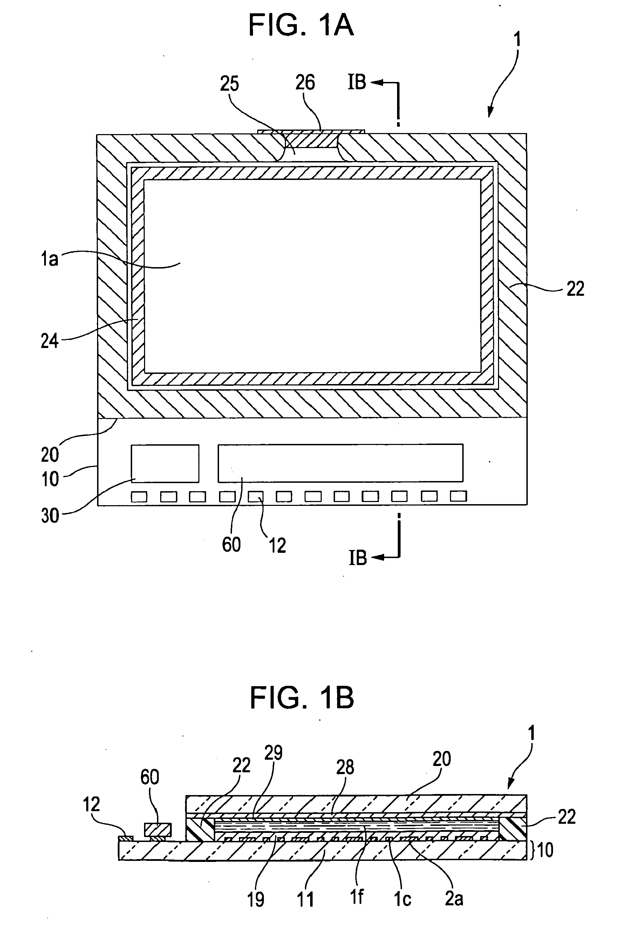

Figs. 1A and 1B are a plan view of a liquid crystal device (electro-optical device) together with the constituent elements formed thereon as viewed from a counter substrate, and a cross-sectional view taken along the line IB-IB, respectively. Figs. 1A and 1 B show a liquid crystal device 1 of this embodiment which may be a TN (Twisted Nematic) mode, an ECB (Electrically Controlled Birefringence) mode, or a VAN (Vertical Aligned Nematic) mode transmissive active matrix liquid crystal device. In the liquid crystal device 1, an element substrate 10 and a counter substrate 20 are bonded to each other using a sealant 22 with liquid crystal 1f interposed therebetween. In the element substrate 10, a data line driving IC 60 and a scanning line driving IC 30 are mounted by a COG (Chip On Glass) method in an end region outside the sealant 22, and mounting terminals 12 are formed along the sides of the substrate. The sealant 22 is an adhesive, formed of photocurable resin or thermally setting resin, which bonds the element substrate 10 and the counter substrate 20 to each other along their peripheries. The sealant 22 contains a gap material, such as glass fiber or glass beads, for maintaining a distance between both substrates at a predetermined value. In the sealant 22, a liquid crystal injection port 25 is formed at a disconnected portion. After liquid crystal 1f is filled, the liquid crystal injection port 25 is sealed using a sealing material 26.

Although the details will be described below, the element substrate 10 is provided with thin-film transistors 1c and pixel electrodes 2a in a matrix arrangement, and an alignment film 19 is formed thereon. The counter substrate 20 is provided with a frame 24(not shown in Fig. 1B) formed of a light-shielding material in a region inside the sealant 22, and a region inside the frame 24 becomes an image display region 1a. On the counter substrate 20, though not shown, a light-shielding film, which is called a black matrix or a. black stripe, is formed in regions facing vertical and horizontal boundary regions of each pixel. A counter electrode 28 and an alignment film 29 are formed on the light-shielding film. Though not shown in Fig. 1B, in a region of the counter substrate 20 facing each pixel of the element substrate 10, RGB color filters are formed together with a protective film. Accordingly, the liquid crystal device 1 can be used as a color display device of an electronic apparatus, such as a mobile computer, a cellular phone, or a liquid crystal television. Configuration of Element Substrate 10

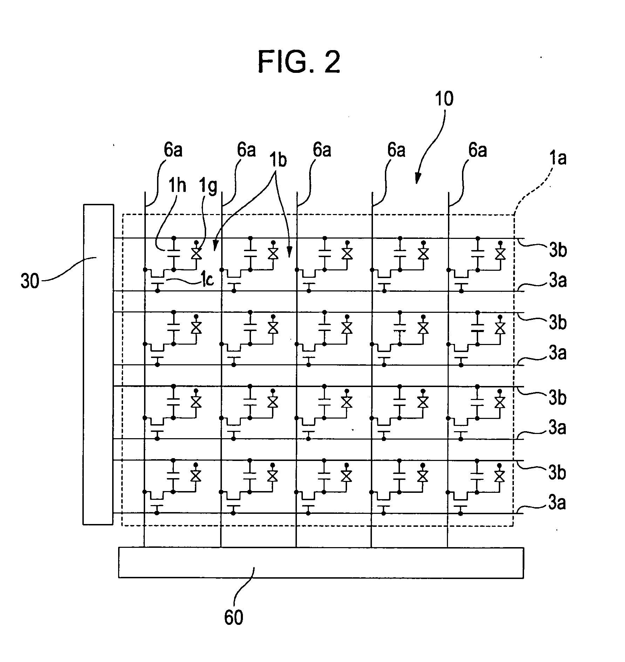

Fig. 2 is an explanatory view showing the electrical configuration of the element substrate of the liquid crystal device shown in Figs. 1A and 1 B. As shown in Fig. 2, in a region of the element substrate 10 corresponding to the image display region 1a, a plurality of source lines 6a (data line) and a plurality of gate lines 3a (scanning line) are formed so as to cross each other, and pixels 1b are formed at intersections of the source lines 6a and the gate lines 3a. The gate lines 3a extend from the scanning line driving IC 30, and the source lines 6a extend from the data line driving IC 60. Further, in the element substrate 10, a pixel-switching thin-film transistor 1c that controls driving of liquid crystal 1f is formed in each of the pixels 1b. A corresponding one of the source lines 6a is electrically connected to a source of the thin-film transistor 1c, and a corresponding one of the gate lines 3a is electrically connected to a gate of the thin-film transistor 1c.

In addition, in the element substrate 10, capacitor lines 3b are formed in parallel with the gate lines 3a. In this embodiment, a liquid crystal capacitor 1g between the element substrate 10 and the counter substrate 20 is connected to the thin-film transistor 1c in series, and a storage capacitor 1h is connected to the liquid crystal capacitor 1g in parallel. Here, the capacitor lines 3b are connected to the scanning line driving IC 30 but have a fixed potential. Moreover, the storage capacitor 1h may be formed from the previous gate line 3a. In this case, the capacitor line 3b may not be provided.

In the liquid crystal device 1 having the above-described configuration, if the thin-film transistor 1c is turned on for a predetermined period, an image signal that is supplied from the source line 6a is written in the liquid crystal capacitor 1g of each pixel 1b at a predetermined timing. The image signal having a predetermined level written in the liquid crystal capacitor 1g is held by the liquid crystal capacitor 1g for a predetermined period, and the storage capacitor 1h prevents the image signal held by the liquid crystal capacitor 1g from leaking.

### Configuration of Each Pixel

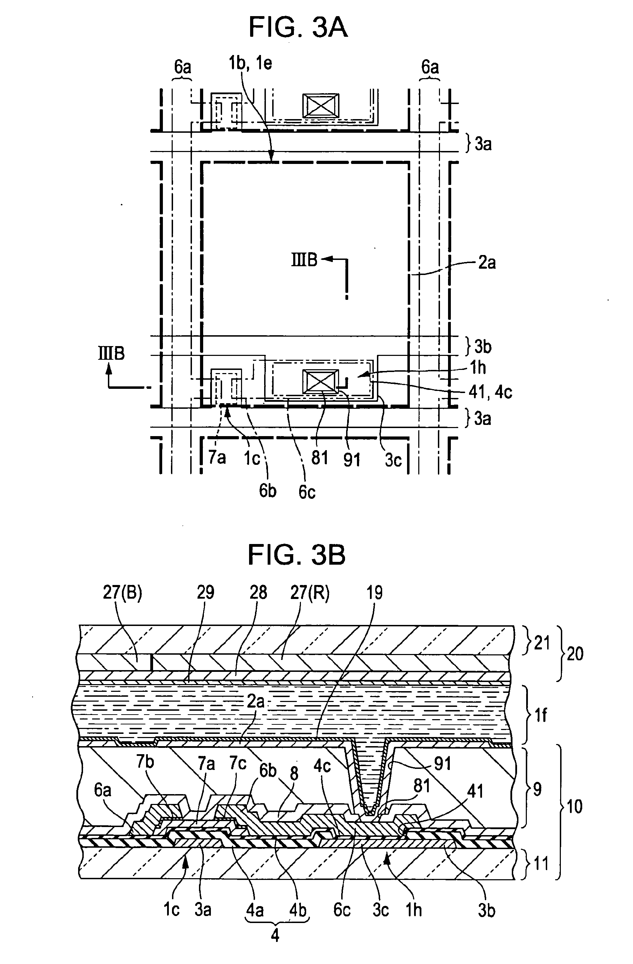

Figs. 3A and 3B are a plan view of one pixel in a liquid crystal device according to the first embodiment of the invention, and a cross-sectional view of the liquid crystal device taken along the line IIIB-IIIB, respectively. In Fig. 3A, the pixel electrode is indicated by a bold and long dotted line, the gate line and a thin film formed along with the gate line are indicated by a thin solid line, the source line and a thin film formed along with the source line are indicated by a thin one-dot-chain line, and a semiconductor layer is indicated by a thin and short dotted line. Further, a portion corresponding to a dielectric layer constituting the storage capacitor is indicated by a thin two-dot-chain line, and a contact hole is indicated by a thin solid line, similarly to the gate line and the like.

As shown in Fig. 3A, on the element substrate 10, the following elements constituting the pixel 1b are provided in the pixel region 1e defined by the gate line 3a and the source line 6a. Further, in the pixel region 1e, a semiconductor layer 7a formed of an amorphous silicon film that constitutes an active layer of a bottom-gate-type thin-film transistor 1c is formed. Further, a gate electrode is formed by a protruding portion from the gate line 3a. In the semiconductor layer 7a constituting the active layer of the thin-film transistor 1c, the source line 6a overlaps as a source electrode at a source-side end, and overlaps as a drain electrode 6b at a drain-side end. In addition, the capacitor line 3b is formed in parallel with the gate line 3a.

Further, in the pixel region 1e, the storage capacitor 1h that has an extended portion from the capacitor line 3b as a lower electrode 3c and an extended portion from the drain electrode 6b as an upper electrode 6c is formed. In addition, the pixel electrode 2a formed of an ITO (indium tin oxide) film is electrically connected to the upper electrode 6c through contact holes 81 and 91.

The cross-section of the element substrate 10 having the above-described configuration taken along the line IIIB-IIIB is as shown in Fig. 3B. First, the gate line 3a (gate electrode) formed of a conductive film, and the capacitor line 3b (the lower electrode 3c of the storage capacitor 1h) are formed on an insulating substrate 11 formed of a glass substrate or a quartz substrate. In this embodiment, the gate line 3a and the capacitor line 3b have a two-layered structure in which a molybdenum film having a thickness of 20 nm is laminated on a magnesium-containing aluminum alloy film having a thickness of 150 nm.

In this embodiment, a gate insulating layer 4 is formed on the gate line 3a to cover the gate line 3a. In a region of an upper layer of the gate insulating layer 4 that partially overlaps the protruding portion (gate electrode) of the gate line 3a, the semiconductor layer 7a that constitutes the active layer of the thin-film transistor 1c is formed. In the semiconductor layer 7a, an ohmic contact layer 7b formed of a doped silicon film and the source line 6a are laminated on the source region, and an ohmic contact layer 7c formed of a doped silicon film and the drain electrode 6b are formed on the drain region, thereby constituting the thin-film transistor 1c. Further, the upper electrode 6c of the storage capacitor 1h is formed from the protruding portion of the drain electrode 6b. In this embodiment, the semiconductor layer 7a is formed of an intrinsic amorphous silicon film having a thickness of 150 nm, and the ohmic contact layers 7b and 7c are formed of an n+ amorphous silicon film having a thickness of 50 nm, in which phosphorus is doped. The source line 6a and the drain electrode 6b (the upper electrode 6c) have a three-layered structure, in which a molybdenum film having a thickness of 5 nm, an aluminum film having a thickness of 1500 nm, and a molybdenum film having a thickness of 50 nm are laminated in that order.

On the source line 6a, the drain electrode 6b, and the upper electrode 6c, a passivation film 8 formed of a silicon nitride film or the like, and a planarizing film 9 formed of a photosensitive resin film, such as acrylic resin, are formed as an interlayer insulating film. The pixel electrode 2a is formed on the planarizing film 9. The pixel electrode 2a is electrically connected to the upper electrode 6c through the contact hole 91 formed in the planarizing film 9 and the contact hole 81 formed in the passivation film 8, and then is electrically connected to a drain region of the thin-film transistor 1c through the upper electrode 6c and the drain electrode 6b. The alignment film 19 is formed on the surface of the pixel electrode 2a. In this embodiment, the passivation film 8 is formed of a silicon nitride film having a thickness of 250 nm, and the pixel electrode 2a is formed of an ITO film having a thickness of 100 nm.

The counter substrate 20 is disposed to face the element substrate 10 having the above-described configuration, and liquid crystal 1f is held between the element substrate 10 and the counter substrate 20. On the counter substrate 20, color filters 27 for respective colors, a counter electrode 28, and the alignment film 29 are formed. The liquid crystal capacitor 1g (see Fig. 2) is formed between the pixel electrode 2a and the counter electrode 28. Moreover, a black matrix or a protective film, which is not shown, may be formed on the counter substrate 20.

### Configuration of Gate Insulating Layer and Dielectric Layer

In the liquid crystal device 1 of this embodiment, the gate insulating layer 4 has a two-layered structure of a lower gate insulating layer 4a formed of a thick silicon nitride film and an upper gate insulating layer formed of a thin silicon nitride film. In this embodiment, the lower gate insulating layer 4a is formed to have a thickness sufficient to reduce an effect of parasitic capacitance of the thin-film transistor, and the upper gate insulating film is formed to be thinner than the lower gate insulating film. For example, the thickness of the lower gate insulating film is in the range of 250 to 500 nm and preferably 300 nm, and the thickness of the upper gate insulating layer 4b is in the range of 50 to 200 nm and preferably 100 nm. The optimum thickness is determined in consideration of writing ability of the thin-film transistor, parasitic capacitance, and a balance of the storage capacitor. For example, when the size of the pixel 1b is small (for example, a short side of one pixel is 40 µm or less) with high definition, the storage capacitor 1h and the liquid crystal capacitor 1g in the pixel 1c are reduced in size, but the minimum size of the thin-film transistor 1c is constrained by resolution of photolithography. For this reason, in the high-definition pixel, a ratio of parasitic capacitance of the thin-film transistor 1c to capacitance of one pixel increases. It has been known that, an increase in this ratio (hereinafter, referred to as 'parasitic capacitance ratio') causes deterioration of display quality, such as flicker, crosstalk, or burning, in the electro-optical device 1. Accordingly, the design thereof is developed in order to considerably reduce the parasitic capacitance ratio. However, when the parasitic capacitance ratio is constrained by a high-definition layout, in the known method, it is difficult to solve this problem. In contrast, if the structure and process according to an embodiment of the invention is used, the thickness of the gate insulating film 4 of the thin-film transistor 1c can be set and manufactured separately from the storage capacitor 1h. That is, in the high-definition pixel, since the gate insulating film is formed to be thicker than that under standard conditions, parasitic capacitance of the thin-film transistor 1c can be reduced and the parasitic capacitance ratio can be decreased. Moreover, in setting such a condition, the current driving ability of the thin-film transistor 1c (signal writing ability in the pixel 1b) is decreased. However, since the writing pixel capacitance of the high-definition pixel is small, even though the gate insulating film is formed thicker in the above-described manner, the design thereof can be developed such that it does not matter in terms of writing ability.

In this embodiment, the lower gate insulating layer 4a of the gate insulating layer 4 is removed over a region, and preferably substantially the entire region, overlapping the lower electrode 3c and the upper electrode 6c of the storage capacitor 1h in plan view in a thickness direction, and an opening 41 is formed. Meanwhile, the upper gate insulating layer 4b is substantially formed on the entire surface. For this reason, the gate insulating layer 4 has a thin portion formed from only the upper gate insulating layer 4b in the region overlapping the lower electrode 3c and the upper electrode 6c in plan view (a region overlapping the opening 41 in plan view). The thin portion constitutes the dielectric layer 4c of the storage capacitor 1h. Here, a thick portion having the same thickness as the gate insulating layer 4 (upper and lower gate insulating layers 4a, 4b) remains on the lower electrode 3c along an edge of the lower electrode 3c, and the dielectric layer 4c is surrounded by the thick insulating film. For this reason, a decrease in withstand voltage that tends to occur at an edge of the lower electrode 3c or an edge of the upper electrode 6c can be prevented.

### Manufacturing Method of Liquid Crystal Device 1

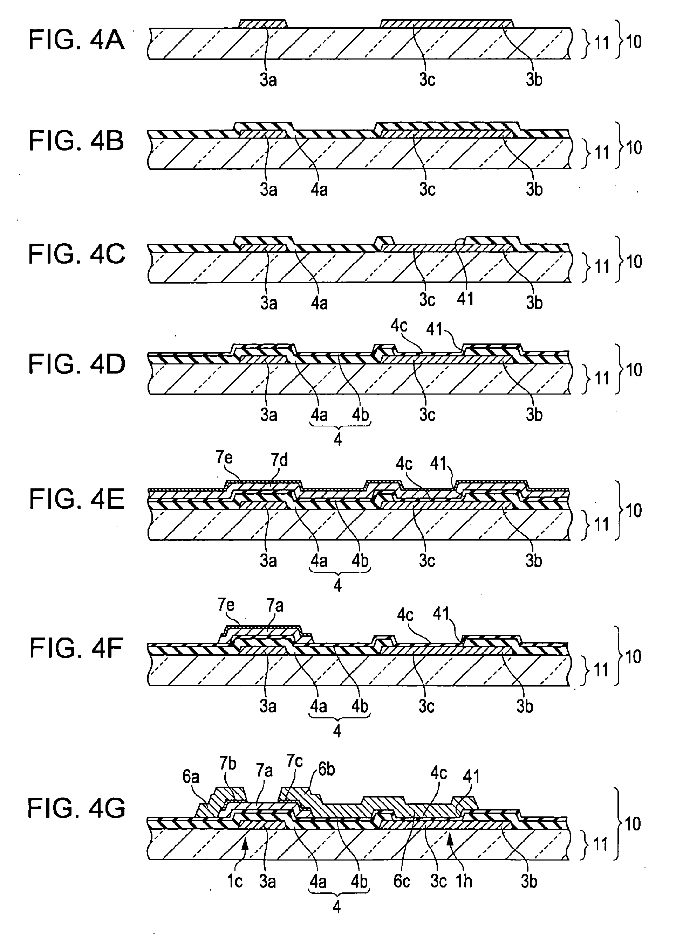

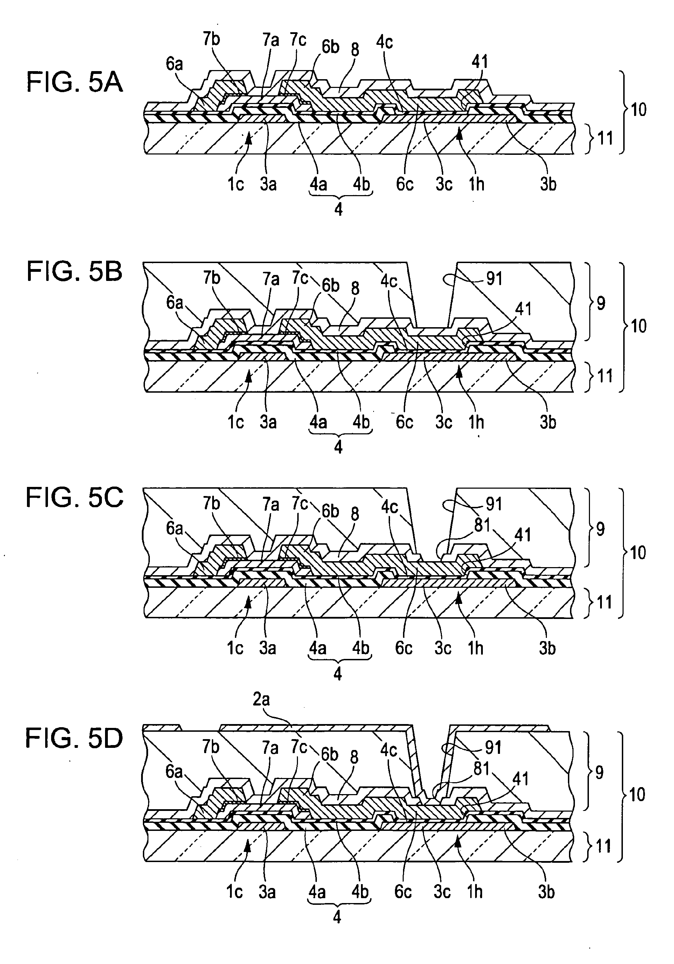

Figs. 4A to 4G and 5A to 5D are cross-sectional views of the element substrate 10 that is used in the liquid crystal device 1 of this embodiment at steps of a manufacturing method thereof. Moreover, in manufacturing the element substrate 10, the following steps may be performed on a large substrate from which a plurality of element substrates 10 are obtained. Hereinafter, a large substrate will also be described as the element substrate 10.

First, in a gate electrode forming step shown in Fig. 4A, a metal film (a laminate of an aluminum alloy film having a thickness of 150 nm and a molybdenum film having a thickness of 20 nm) is formed on an insulating substrate 11. such as a large glass substrate. Then, the metal film is patterned using a photolithography technology to simultaneously form the gate line 3a (gate electrode) and the capacitor line 3b (lower electrode 3c).

Next, a gate insulating layer forming step is performed. In this embodiment, at the gate insulating layer forming step, first, the thick lower gate insulating layer 4a that constitutes a lower layer of the gate insulating layer 4 is formed using a plasma CVD method at a lower gate insulating layer forming step shown in Fig. 4B. In this embodiment, the lower gate insulating layer 4a is formed of a silicon nitride film having a thickness of approximately 300 nm.

Next, at a lower gate insulating layer etching step shown in Fig. 4C, a resist mask (not shown) having an opening is formed in a region overlapping the lower electrode 3c in plan view using a photolithography technology, and then reactive ion etching (dry etching) by a fluorine-based etching gas, such as SF_{6,} is performed on the lower gate insulating layer 4a, thereby forming the opening 41. Such reactive ion etching uses a synergy effect of a physical sputtering effect of ions and a chemical etching effect of radicals, and thus excellent anisotropy and high productivity are achieved.

Next, at an upper gate insulating layer forming step shown in Fig. 4D, the thin upper gate insulating layer 4b that constitutes the upper layer of the gate insulating layer 4 is formed using a plasma CVD method. In this embodiment, the upper gate insulating layer 4b is formed of a silicon nitride film having a thickness of approximately 100 nm. As a result, on the gate line 3a (gate electrode), the gate insulating layer 4 having the thick lower gate insulating layer 4a and the thin upper gate insulating layer 4b is formed. Meanwhile, in the region that overlaps the opening 41 in plan view, the dielectric layer 4c having only the upper gate insulating layer 4b is formed.

Next, at a semiconductor layer forming step shown in Fig. 4E, the intrinsic amorphous silicon film 7d having a thickness of 150 nm and the n+ silicon film 7e having a thickness of 50 nm are successively formed using a plasma CVD method. At that time, in a state where the element substrate 10 subjected to the upper gate insulating layer forming step shown in Fig. 4D is kept under a vacuum atmosphere, the semiconductor layer forming step shown in Fig. 4E is performed, such that the element substrate 10 is not exposed to air. Accordingly, in a state where the surface of the gate insulating layer 4 (upper gate insulating layer 4b) is kept clean, the amorphous silicon film 7d can be laminated thereon.

Next, as shown in Fig. 4F, the amorphous silicon film 7d and the n+ silicon film 7e are etched using a photolithography technology, thereby forming an island-shaped semiconductor layer 7a and an island-shaped n+ silicon film 7e. In this case, reactive ion etching (dry etching) that uses a fluorine-based etching gas, such as SF₆ or the like, is also performed.

Next, as shown in Fig. 4G, a metal film (a laminate of a molybdenum having a thickness of 5 nm, an aluminum film having a thickness of 1500 nm,and a molybdenum film having a thickness of 50 nm) is formed and then patterned using a photolithography technology, thereby forming the source line 6a, the drain electrode 6b, and the upper electrode 6c. Subsequently, the n+ silicon film 7e between the source line 6a and the drain electrode 6b is removed by etching with the source line 6a and the drain electrode 6b as a mask, thereby separating the source and the drain from each other. As a result, the n+ silicon film 7e is removed from a region where the source line 6a and the drain electrode 6b are not formed, thereby forming the ohmic contact layers 7b and 7c. At that time, a portion of the surface of the semiconductor layer 7a is etched. In such a manner, the bottom-gate-type pixel-switching thin-film transistor 1c is formed, and simultaneously the storage capacitor 1h is formed.

Next, as shown in Fig. 5A, the passivation film 8 formed of a silicon nitride film having a thickness of 250 nm is formed using a plasma CVD method.

Next, as shown in Fig. 5B, photosensitive resin, such as acrylic resin or the like, is coated using a spin coating method, and then subject to exposure and development, thereby forming the planarizing film 9 having the contact hole 91.

Next, as shown in Fig. 5C, etching is performed on the passivation film 8 using a photolithography technology, thereby forming the contact hole 81 at a position overlapping the contact hole 91. In this case, reactive ion etching (dry etching) that uses a fluorine-based etching gas, such as SF₆ or the like, is also performed.

Next, as shown in Fig. 5D, an ITO film having a thickness of 100 nm is formed using a sputtering method and then patterned using photolithography technology and wet etching, thereby forming the pixel electrode 2a. As a result, the pixel electrode 2a is electrically connected to the upper electrode 6c through the contact holes 91 and 81. Subsequently, a polyimide film for forming the alignment film 19 shown in Fig. 3B is formed and subjected to a rubbing treatment.

The element substrate 10 as a large substrate, on which various wiring lines and TFTs are formed, is bonded to a large counter substrate 20 formed separately by the sealant 22, and cut at a predetermined size. Then, since the liquid crystal injection port 25 is opened, liquid crystal 1f is filled between the element substrate 10 and the counter substrate 20 from the liquid crystal injection port 25, and then the liquid crystal injection port 25 is sealed using the sealing material 26.

### Main Effects of This Embodiment

As described above, in the liquid crystal device 1 of this embodiment, since the thin-film transistor 1c has a bottom gate type, the upper gate insulating film 4b, the intrinsic amorphous silicon film 7d constituting the active layer (semiconductor layer 7a), and the n+ silicon film 7e constituting the ohmic contact layers 7b and 7c can be successively formed. Accordingly, the amorphous silicon film 7d can be formed on the clean upper gate insulating film 4b. Besides, in this embodiment, when the upper gate insulating film 4b, the amorphous silicon film 7d, and the ohmic contact layers 7b and 7c are formed, the element substrate 10 is kept under the vacuum atmosphere. Accordingly, the surface of the upper gate insulating film 4b can be reliably prevented from being contaminated. For this reason, the interface of the gate insulating layer 4 and the semiconductor layer 7a is clean, and reliability of the thin-film transistor 1c is high.

Further, since the thickness of the dielectric layer 4c of the storage capacitor 1h is a quarter of the thickness of the gate insulating layer 4, capacitance per unit area becomes four times. Besides, the upper gate insulating layer 4b constituting the dielectric layer 4c is formed of the silicon nitride film (dielectric constant is approximately 7 to 8) having a dielectric constant larger than a silicon oxide film. Accordingly, the storage capacitor 1h has high capacitance per unit area. For this reason, the storage capacitor 1h has a high charge holding property. If the space is reduced as the capacitance value per unit area is increased, a pixel aperture ratio can be increased.

In this embodiment, in a case where the portion of the gate insulating layer 4 that is partially reduced in thickness is used as the dielectric layer 4c of the storage capacitor 1h, the lower gate insulating layer 4a does not remain, and the dielectric layer 4c is formed by only the upper gate insulating layer 4b. Accordingly, unlike a case where the lower gate insulating layer 4a partially remains, a variation in capacitance of the storage capacitor 1h due to a variation in etching depth can be prevented.

In this embodiment, in a case where the portion of the gate insulating layer 4 that is partially reduced in thickness is used as the dielectric layer 4c of the storage capacitor 1h, of the lower gate insulating layer 4a and the upper gate insulating layer 4b, the lower gate insulating layer 4a is removed, and the upper gate insulating layer 4b formed on the lower gate insulating layer 4a is used as the dielectric layer 4c of the storage capacitor 1h. With the upper gate insulating layer 4b, there is no effect of static electricity or plasma when the lower gate insulating layer 4a is removed by dry etching. Accordingly, a defect density of the upper gate insulating layer 4b is low. For this reason, an inconsistency, such as lowering of a withstand voltage of the storage capacitor 1h, can be prevented. For example, in respects to the dielectric layer 4c of the storage capacitor 1h (lower gate insulating layer 4a) described with reference to Figs. 15A to 15E, a defect density is 0.2 piece/cm² due to static electricity or plasma, Meanwhile, in respects to the dielectric layer 4c of the storage capacitor 1 h (the upper gate insulating layer 4b) of this embodiment, there is no effect static electricity or plasma, and thus a defect density is markedly small, for example, 0.01 piece/cm². If such a defect density is changed in a 2.4-inch HVGA system liquid crystal panel, while a defect occurrence rate is 20% in the liquid crystal device 1 having the storage capacitor 1h described with reference to Figs. 15A to 15E, a defect occurrence rate can be reduced to 1% in the liquid crystal device 1 having the storage capacitor 1h of this embodiment.

Moreover, in this embodiment, dry etching is performed on the lower gate insulating layer 4a, thereby forming the opening 41, but the opening 41 may be formed by wet etching. In this case, since the upper gate insulating layer 4b is not exposed to the etchant for the lower gate insulating layer 4a, pin holes do not occur in the upper gate insulating layer 4b. For this reason, a withstand voltage of the storage capacitor 1h can be prevented from being varied.

### Second Embodiment

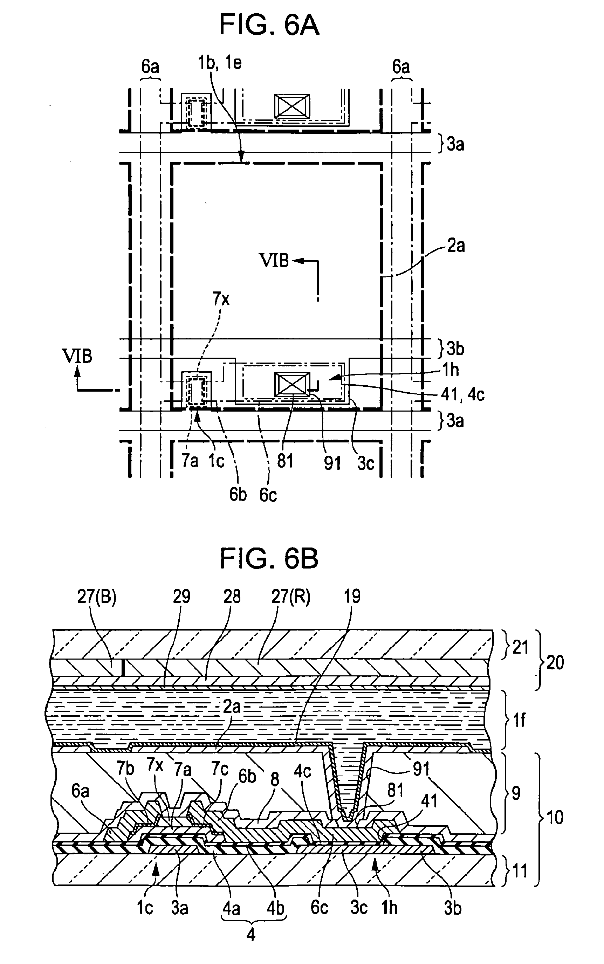

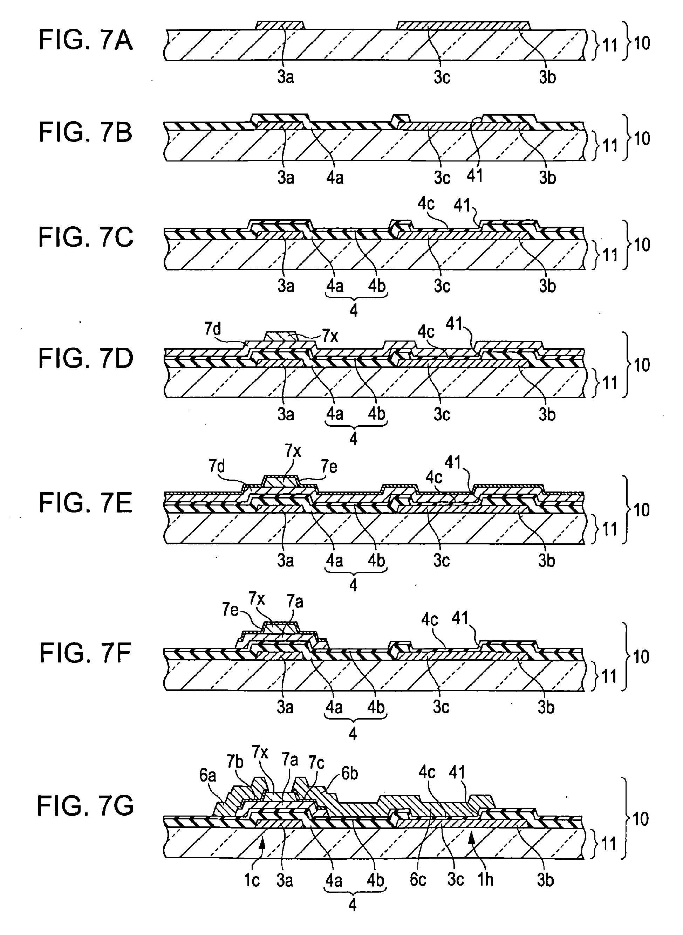

Figs. 6A and 6B are a plan view of one pixel in a liquid crystal device according to a second embodiment of the invention, and a cross-sectional view of the liquid crystal device taken along the line VIB-VIB, respectively. Figs. 7A to 7G are process cross-sectional views showing steps until the source and drain electrodes are formed, in a manufacturing process of the element substrate 10 that is used in the liquid crystal device 1 of this embodiment. In Fig. 6A, the pixel electrode is indicated by a bold and long dotted line, the gate line and the thin film formed along with the gate line are indicated by a thin solid line, the source line and the thin film formed along with the source line are indicated by a thin one-dot-chain line, and the semiconductor layer is indicated by a thin and short dotted line. Further, a portion corresponding to dielectric layer constituting the storage capacitor is indicated by a thin two-dot-chain line, and the contact hole is indicated by a thin solid line, similarly to the gate line and the like. In addition, an etching stopper layer is indicated by a bold and short line. Moreover, since the basic configuration of this embodiment is the same as the first embodiment, the same parts are represented by the same reference numerals, and the descriptions thereof will be omitted.

As shown in Figs. 6A and 6B, in this embodiment, like the first embodiment, on an element substrate 10, a bottom-gate-type thin-film transistor 1c and a storage capacitor 1h are formed in a pixel region 1 e defined by a gate line 3a and a source line 6a. The storage capacitor 1h has an extended portion from a capacitor line 3b as a lower electrode 3c and an extended portion from a drain electrode 6b as an upper electrode 6c. Like the first embodiment, a gate insulating layer 4 has a two-layered structure of a lower gate insulating layer 4a formed of a thick silicon nitride film and an upper gate insulating layer formed of a thin silicon nitride film. The lower gate insulating layer 4a is removed over the region that overlaps the lower electrode 3c and the upper electrode 6c of the storage capacitor 1h in plan view in the depthwise direction, thereby forming an opening 41. For this reason, a dielectric layer 4c of the storage capacitor 1h is formed from a thin portion (upper gate insulating layer 4b) of the gate insulating layer 4. Moreover, an insulating film having the same thickness as the gate insulating layer 4 (upper and lower gate insulating layers 4a, 4b) is formed on the lower electrode 3c along the edge of the lower electrode 3c, and the dielectric layer 4c is surrounded by the thick insulating film.

In this embodiment, an etching stopper layer 7x is formed in a region between an end of the source line 6a (source electrode) and an end of the drain electrode 6b on the semiconductor layer 7a, and ohmic contact layers 7b and 7c are initially formed to cover the etching stopper layer 7x. In this embodiment, the etching stopper layer 7x is formed of a silicon nitride film having a thickness of 150 nm. Other parts are the same as those in the first embodiment, and thus the descriptions thereof will be omitted.

In manufacturing the element substrate 10 having the above-described configuration, at a gate electrode forming step shown in Fig. 7A, a metal film (a laminate of an aluminum alloy film and a molybdenum film) is formed on the surface of an insulating substrate 11. Then, the metal film is patterned using a photolithography technology, thereby forming the gate line 3a (gate electrode), and the capacitor line 3b (lower electrode 3c).

Next, a gate insulating layer forming step is performed. In this embodiment, like the first embodiment, at a lower gate insulating layer forming step shown in Fig. 7B, a thick silicon nitride film (lower gate insulating layer 4a) constituting a lower layer of the gate insulating layer 4 is formed using a plasma CVD method, and at a lower gate insulating layer etching step, etching is performed on the lower gate insulating layer 4a, thereby forming the opening 41 at a position overlapping the lower electrode 3c. Next, at an upper gate insulating layer forming step shown in Fig. 7C, a thin silicon nitride film (upper gate insulating layer 4b) constituting an upper layer of the gate insulating layer 4 is formed.

Next, at a semiconductor layer forming step shown in Fig. 7D, an intrinsic amorphous silicon film 7d is formed using a plasma CVD method. At that time, in a state where the element substrate 10 subjected to the upper gate insulating layer forming step shown in Fig. 7C is kept under the vacuum atmosphere, the semiconductor layer forming step shown in Fig. 7D is performed, such that the element substrate 10 is not exposed to air. Accordingly, in a state where the surface of the gate insulating layer 4 (upper gate insulating layer 4b) is kept clean, the amorphous silicon film 7d (active layer) can be laminated thereon. Next, a silicon nitride film having a thickness of 150 nm is formed on the amorphous silicon film 7d and then etched, thereby forming the etching stopper layer 7x. In this case, reactive ion etching (dry etching) that uses a fluorine-based etching gas, such as SF₆ or the like, is also performed.

Next, as shown in Fig. 7E, an n+ silicon film 7e is formed on the etching stopper layer 7x. Next, as shown in Fig. 7F, dry etching is performed on amorphous silicon film 7d and the n+ silicon film 7e using a photolithography technology, thereby forming an island-shaped semiconductor layer 7a and an n+ silicon film 7e.

Next, as shown in Fig. 7G, a metal film (a laminate of a molybdenum film, an aluminum film, and a molybdenum film) is formed and then patterned using a photolithography technology, thereby forming a source line 6a, a drain electrode 6b, and an upper electrode 6c. Subsequently, the n+ silicon film 7e between the source line 6a and the drain electrode 6b is removed by etching with the source line 6a and the drain electrode 6b as a mask, thereby separating the source and the drain from each other. As a result, the n+ silicon film 7e is removed from a region where the source line 6a and the drain electrode 6b are not formed, thereby forming the ohmic contact layers 7b and 7c. At that time, the etching stopper layer 7x has a function of protecting the semiconductor layer 7a. In such a manner, the bottom-gate-type pixel-switching thin-film transistor 1c is formed and simultaneously the storage capacitor 1h is formed. Subsequent steps are the same as those in the first embodiment, and the descriptions thereof will be omitted.

As described above, in this embodiment, the basic configuration of the storage capacitor 1h is the same as the first embodiment. Accordingly, the same effects as the first embodiment can be obtained. That is, the thin-film transistor 1c having high reliability can be formed and the storage capacitor 1h having high capacitance and stable withstand voltage can be formed.

Further, as shown in Fig. 7D, in forming the etching stopper layer 7x, the amorphous silicon film 7d has a function of protecting the upper gate insulating layer 4b. For this reason, even though the etching stopper layer 7x is formed, defects can be prevented from occurring in the upper gate insulating layer 4b used as the dielectric layer 4c.

### Third Embodiment

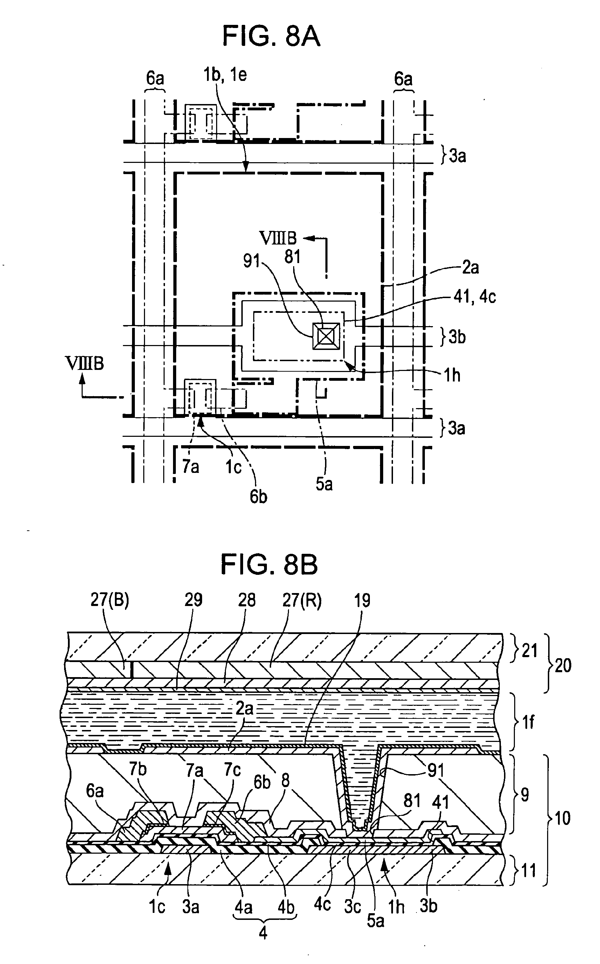

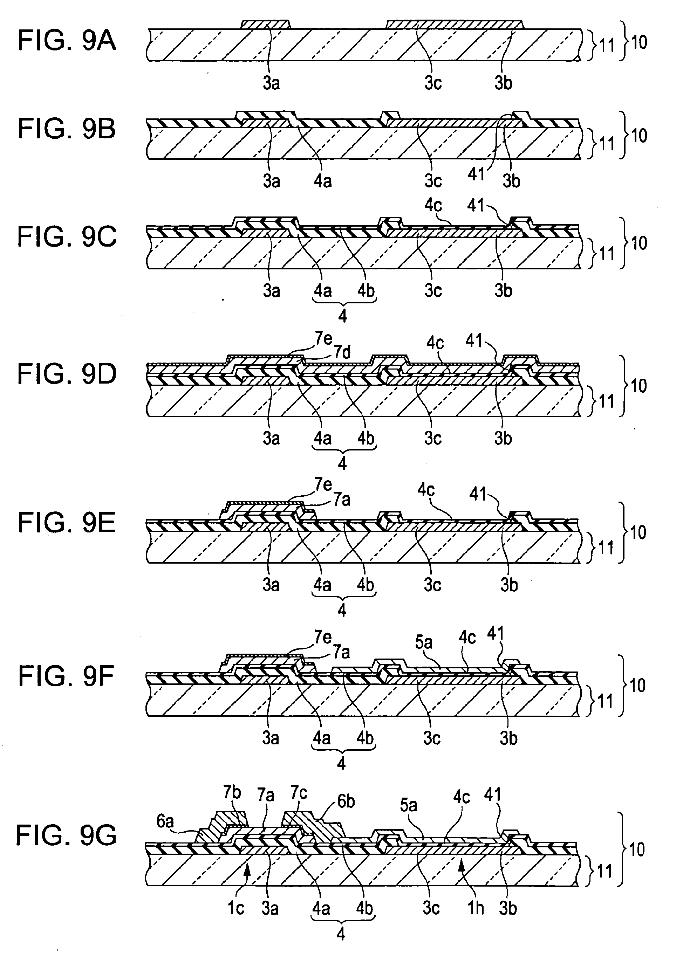

Figs. 8A and 8B are a plan view of one pixel in a liquid crystal device according to a third embodiment of the invention, and a cross-sectional view of the liquid crystal device taken along the line VIIIB-VIIIB, respectively. Figs. 9A to 9G are process cross-sectional views showing steps until the source and the drain electrodes are formed, in a manufacturing process of the element substrate 10 that is used in the liquid crystal device 1 of this embodiment. In Fig. 8A, the pixel electrode is indicated by a bold and long dotted line, the gate line and the thin film formed along with the gate line are indicated by a thin solid line, the source line and the thin film formed along with the source line are indicated by a thin one-dot-chain line, and the semiconductor layer is indicated by a thin and short dotted line. Further, the portion corresponding to the dielectric layer constituting the storage capacitor is indicated by a thin two-dot-chain line, and the contact hole is indicated by a thin solid line, similarly to the gate line and the like. In addition, the upper electrode of the storage capacitor is indicated by a bold one-dot-chain line. Moreover, since the basic configuration of this embodiment is the same as the first embodiment, the same parts are represented by the same reference numerals, and the descriptions thereof will be omitted.

As shown in Figs. 8A and 8B, in this embodiment, like the first embodiment, on the element substrate 10, a bottom-gate-type thin-film transistor 1c and a storage capacitor 1h are formed in the pixel region 1 e defined by a gate line 3a and a source line 6a.

This embodiment is the same as the first embodiment in that the storage capacitor 1h has a protruding portion from a capacitor line 3b as a lower electrode 3c. However, an upper electrode 5a of the storage capacitor 1h is formed of an ITO film that is formed between a gate insulating layer 4 and a drain electrode 6b, and the upper electrode 5a is electrically connected to the drain electrode 6b by a portion that partially overlaps the drain electrode 6b. In this embodiment, the thickness of the ITO film constituting the upper electrode 5a is 50 nm. Moreover, a pixel electrode 2a formed on a planarizing film 9 is electrically connected to the upper electrode 5a through contact holes 81 and 91.

Like the first embodiment, the gate insulating layer 4 has a two-layered structure of a lower gate insulating layer 4a formed of a thick silicon nitride film and an upper gate insulating layer formed of a thin silicon nitride film. The lower gate insulating layer 4a is removed over the region overlapping the lower electrode 3c and the upper electrode 5a of the storage capacitor 1h in plan view in a depthwise direction, thereby forming an opening 41. For this reason, a dielectric layer 4c of the storage capacitor 1h is formed from a thin portion (upper gate insulating layer 4b) of the gate insulating layer 4. Moreover, an insulating film having the same thickness as the gate insulating layer 4 (upper and lower gate insulating layers 4a, 4b) is formed on the lower electrode 3c along the edge of the lower electrode 3c, and the dielectric layer 4c is surrounded by the thick insulating film. Other parts are the same as those in the first embodiment, and thus the descriptions thereof will be omitted.

In manufacturing the element substrate 10 having the above-described configuration, at a gate electrode forming step shown in Fig. 9A, a metal film (a laminate of an aluminum alloy film and a molybdenum film) is formed on the surface of an insulating substrate 11. Then, the metal film is patterned using a photolithography technology, thereby forming the gate line 3a (gate electrode) and the capacitor line 3b (lower electrode 3c).

Next, a gate insulating layer forming step is performed. In this embodiment, like the first embodiment, at a lower gate insulating layer forming step shown in Fig. 9B, a thick silicon nitride film (lower gate insulating layer 4a) constituting the lower layer of the gate insulating layer 4 is formed using a plasma CVD method, and at a lower gate insulating layer etching step, etching is performed on the lower gate insulating layer 4a, thereby forming the opening 41 at a position overlapping the lower electrode 3c. Next, at an upper gate insulating layer forming step shown in Fig. 9C, a thin silicon nitride film (upper gate insulating layer 4b) constituting the upper layer of the gate insulating layer 4 is formed.

Next, at a semiconductor layer forming step shown in Fig. 9D, an intrinsic amorphous silicon film 7d and an n+ silicon film 7e are sequentially formed. At that time, in a state where the element substrate 10 subjected to the upper gate insulating layer forming step shown in Fig. 9C is kept under the vacuum atmosphere, a semiconductor layer forming step shown in Fig. 9D is performed, such that the element substrate 10 is not exposed to air. Accordingly, in a state where the surface of the gate insulating layer 4 (upper gate insulating layer 4b) is kept clean, the amorphous silicon film 7d (active layer) can be laminated thereon.

Next, as shown in Fig. 9E, dry etching is performed on the amorphous silicon film 7d and the n+ silicon film 7e using a photolithography technology, thereby forming an island-shaped semiconductor layer 7a and an island-shaped n+ silicon film 7e.

Next, at an upper electrode forming step shown in Fig. 9F, an ITO film having a thickness of 50 nm is formed using a sputtering method, and then wet etching is performed on the ITO film using a photolithography technology, thereby forming the upper electrode 5a. In such a manner, the storage capacitor 1h is formed.

Next, as shown in Fig. 9G, a metal film (a laminate of a molybdenum film, an aluminum film, and a molybdenum film) is formed, and then patterned using a photolithography technology, thereby forming the source line 6a, and the drain electrode 6b. Subsequently, the n+ silicon film 7e between the source line 6a and the drain electrode 6b is removed by etching with the source line 6a and the drain electrode 6b as a mask, thereby separating the source and the drain from each other. As a result, the n+ silicon film 7e is removed from a region where the source line 6a and the drain electrode 6b are not formed, thereby forming ohmic contact layers 7b and 7c. In such a manner, the bottom-gate-type pixel-switching thin-film transistor 1c is formed. Subsequent steps are the same as those in the first embodiment, and thus the descriptions thereof will be omitted.

As described above, in this embodiment, the basic configuration of the storage capacitor 1h is the same as the first embodiment. Accordingly, the same effects as the first embodiment can be obtained. That is, the thin-film transistor 1c having high reliability can be formed, and the storage capacitor 1h having high capacitance and stable withstand voltage can be formed.

Further, since the ITO film (transparent electrode) is used as the upper electrode 5a, a pixel aperture ratio can be increased, compared with a case where the extended portion of the drain electrode 6b is used as the upper electrode.

### Fourth Embodiment

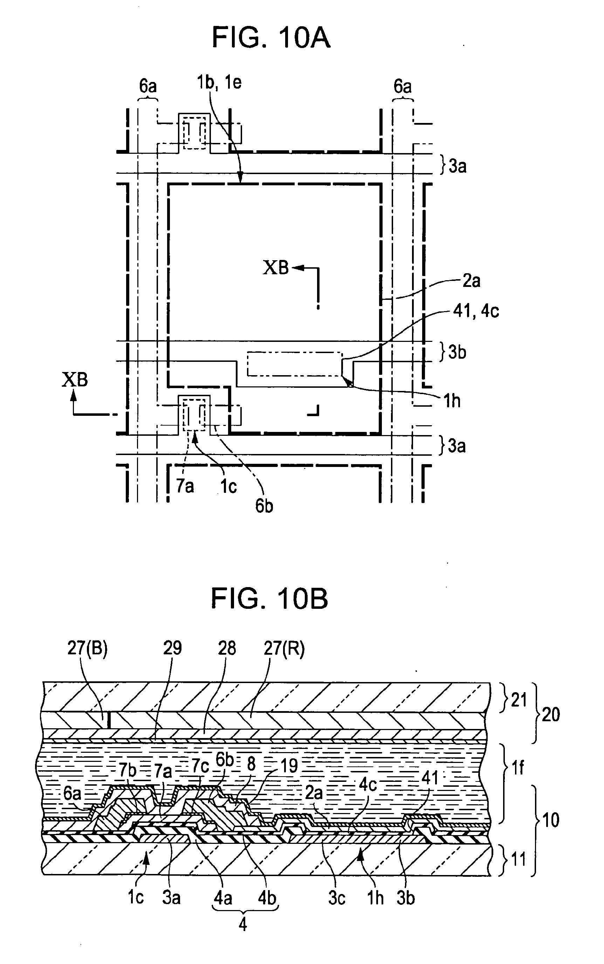

Figs. 10A and 10B are a plan view of one pixel in a liquid crystal device according to a fourth embodiment of the invention, and a cross-sectional view of the liquid crystal device taken along the line XB-XB, respectively. Figs. 11A to 11G are process cross-sectional views showing steps until the source and drain electrodes are formed in a manufacturing process of the element substrate 10 that is used in the liquid crystal device 1 of this embodiment. In Fig. 10A, the pixel electrode is indicated by a bold and long dotted line, the gate line and the thin film formed along with the gate line are indicated by a thin solid line, the source line and the thin film formed along with the source line are indicated by a thin one-dot-chain line, and the semiconductor layer is indicated by a thin and short dotted line. Further, the portion corresponding to the dielectric layer constituting the storage capacitor is indicated by a thin two-dot-chain line. Moreover, since the basic configuration of this embodiment is the same as the first embodiment, the same parts are represented by the same reference numerals, and the descriptions thereof will be omitted.

As shown in Fig. 10A and 10B, in this embodiment, like the first embodiment, on the element substrate 10, a bottom-gate-type thin-film transistor 1c and a storage capacitor 1h are formed in the pixel region 1e defined by the gate line 3a and the source line 6a. However, unlike the first to third embodiments, in this embodiment, a planarizing film is not formed, and a pixel electrode 2a is formed between a gate insulating layer 4 and a drain electrode 6b and electrically connected to the drain electrode 6b by a portion that overlaps the drain electrode 6b.

This embodiment is the same as the first embodiment in that the storage capacitor 1h has a protruding portion from the capacitor line 3b as a lower electrode 3c. However, an upper electrode of the storage capacitor 1h is formed by a portion of the pixel electrode 2a that overlaps the lower electrode 3c in plan view.

Like the first embodiment, the gate insulating layer 4 has a two-layered structure of a lower gate insulating layer 4a formed of a thick silicon nitride film and an upper gate insulating layer formed of a thin silicon nitride film. The lower gate insulating layer 4a is removed over the region overlapping the lower electrode 3c of the storage capacitor 1h and the pixel electrode 2a in plan view in a depthwise direction, thereby forming an opening 41. For this reason, a dielectric layer 4c of the storage capacitor 1h is formed from a thin portion (upper gate insulating layer 4b) of the gate insulating layer 4. Moreover, an insulating film having the same thickness as the gate insulating layer 4 (upper and lower gate insulating layer 4a, 4b) is formed on the lower electrode 3c along the edge of the lower electrode 3c, and the dielectric layer 4c is surrounded by the thick insulating film. Other parts are the same as those in the first embodiment, and thus the descriptions thereof will be omitted.

In manufacturing the element substrate 10 having the above-described configuration, at a gate electrode forming step shown in Fig. 11A, a metal film (a laminate of an aluminum alloy film and a molybdenum film) is formed on the surface of an insulating substrate 11. Then, the metal film is patterned using a photolithography technology, thereby forming the gate line 3a (gate electrode) and the capacitor line 3b (lower electrode 3c).

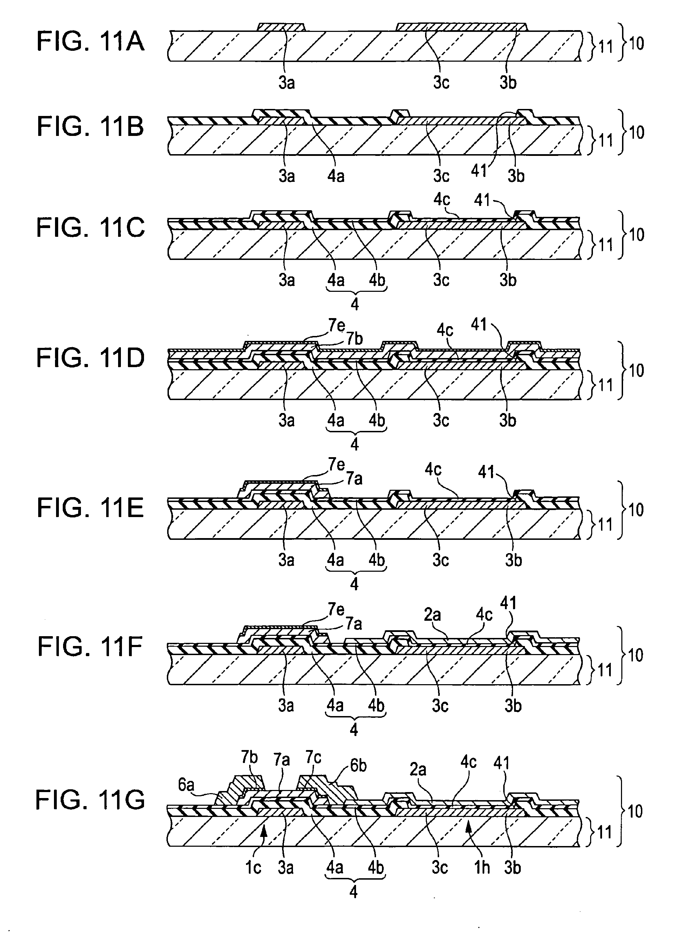

Next, a gate insulating layer forming step is performed. In this embodiment, like the first embodiment, at a lower gate insulating layer forming step shown in Fig. 11B, a thick silicon nitride film (lower gate insulating layer 4a) constituting the lower layer of the gate insulating layer 4 is formed using a plasma CVD method, and at a lower gate insulating layer etching step, etching is performed on the lower gate insulating layer 4a, thereby forming the opening 41 at a position overlapping the lower electrode 3c. Next, at an upper gate insulating layer forming step shown in Fig. 11C, a thin silicon nitride film (upper gate insulating layer 4b) constituting the upper layer of the gate insulating layer 4 is formed.

Next, at a semiconductor layer forming step shown in Fig. 11D, an intrinsic amorphous silicon film 7d and an n+ silicon film 7e are sequentially formed. At that time, in a state where the element substrate 10 subjected to the upper gate insulating layer forming step shown in Fig. 11C is kept under the vacuum atmosphere, a semiconductor layer forming step shown in Fig. 11D is performed, such that the element substrate 10 is not exposed to air. Accordingly, in a state where the surface of the gate insulating layer 4 (upper gate insulating layer 4b) is kept clean, the amorphous silicon film 7d (active layer) can be laminated thereon.

Next, as shown in Fig. 11E, dry etching is performed on the amorphous silicon film 7d and the n+ silicon film 7e using a photolithography technology, thereby forming an island-shaped semiconductor layer 7a and an island-shaped n+ silicon film 7e.

Next, at a pixel electrode forming step (upper electrode forming step) shown in Fig. 11F, an ITO film is formed, and then etching is performed on the ITO film using a photolithography technology, thereby forming a pixel electrode 2a. In such a manner, the storage capacitor 1h is formed.

Next, as shown in Fig. 11G, a metal film (a laminate of a molybdenum film, an aluminum film, and a molybdenum film) is formed and then patterned using a photolithography technology, thereby forming the source line 6a and the drain electrode 6b. Subsequently, the n+ silicon film 7e between the source line 6a and the drain electrode 6b is removed by etching with the source line 6a and the drain electrode 6b as a mask, thereby separating the source and the drain from each other. As a result, the n+ silicon film 7e is removed from a region where the source line 6a and the drain electrode 6b are not formed, thereby forming ohmic contact layers 7b and 7c. In such a manner, the bottom-gate-type pixel-switching thin-film transistor 1c is formed. Subsequent steps are the same as those in the first embodiment, and thus the descriptions thereof will be omitted.

As described above, in this embodiment, the basic configuration of the storage capacitor 1h is the same as the first embodiment. Accordingly, the same effects as the first embodiment can be obtained. That is, the thin-film transistor 1c having high reliability can be formed, and the storage capacitor 1h having high capacitance and stable withstand voltage can be formed.

Further, since a portion of the pixel electrode 2a formed of the ITO film (transparent electrode) is used as the upper electrode of the storage capacitor 1h, a pixel aperture ratio can be increased, compared with a case where the extended portion of the drain electrode 6b is used as the upper electrode.

### Fifth Embodiment

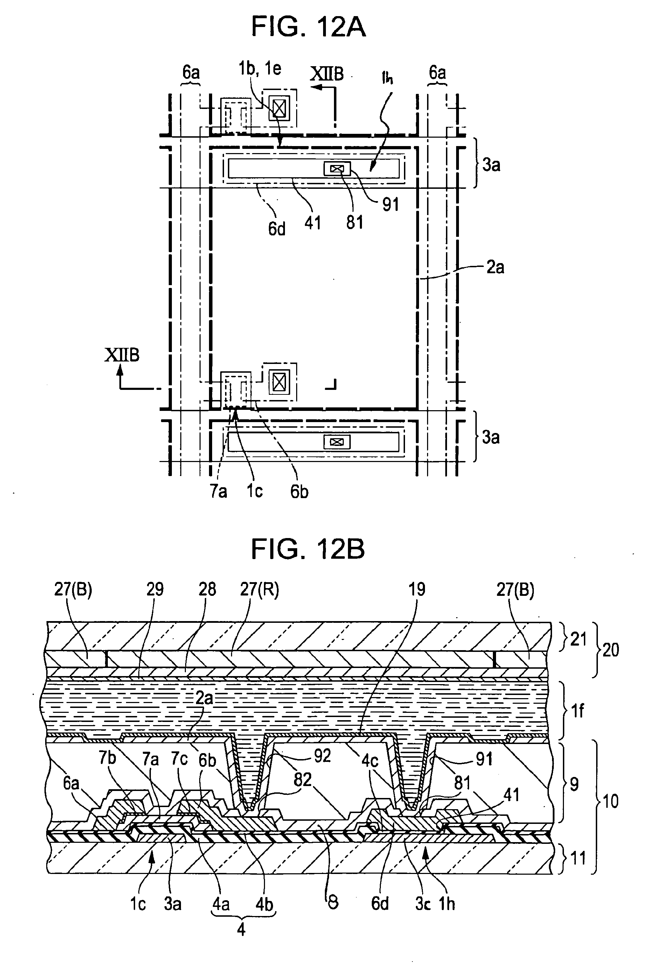

Figs. 12A and 12B are a plan view of one pixel in a liquid crystal device according to a fifth embodiment of the invention, and a cross-sectional view of the liquid crystal device taken along the line XIIB-XIIB, respectively. In Fig. 12A, the pixel electrode is indicated by a bold and long dotted line, the gate line and the thin film formed along with the gate line are indicated by a thin solid line, the source line and the thin film formed along with the source line are indicated by a thin one-dot-chain line, and the semiconductor layer is indicated by a thin and short dotted line. Further, the portion of the dielectric layer constituting the storage capacitor is indicated by a thin solid line, and the contact hole is also indicated by a thin solid line, similarly to the gate line and the like. Moreover, since the basic configuration of this embodiment is the same as the first embodiment, the same parts are represented by the same reference numerals, and the descriptions thereof will be omitted.

As shown in Figs. 12A and 12B, in this embodiment, like the first embodiment, on the element substrate 10, a bottom-gate-type thin-film transistor 1c and a storage capacitor 1h are formed in the pixel region 1 e defined by the gate line 3a and the source line 6a. However, unlike the first to fourth embodiments, in this embodiment, a capacitor line is not formed, and a lower electrode 3c of the storage capacitor 1h is formed from a portion of a previous gate line 3a - that is, a gate line adjacent in a scanning direction (a direction crossing the extension direction of the gate line 3a/an extension direction of the source line 6a).

Further, in the storage capacitor 1h, an upper electrode 6d is formed in a region overlapping the lower electrode 3c. In this embodiment, as the upper electrode 6d, a metal layer formed along with the source line 6a or the drain electrode 6b is used. Here, the upper electrode 6d is formed to be separated from the drain electrode 6b. For this reason, the pixel electrode 2a formed on the planarizing film 9 is electrically connected to the upper electrode 6d through the contact hole 81 of the passivation film 8 and the contact hole 91 of the planarizing film 9. Then, the pixel electrode 2a is electrically connected to the drain electrode 6b through the contact hole 82 of the passivation film 8 and the contact hole 92 of the planarizing film 9.

Like the first embodiment, the gate insulating layer 4 has a two-layered structure of a lower gate insulating layer 4a formed of a thick silicon nitride film and an upper gate insulating layer formed of a thin silicon nitride film. The lower gate insulating layer 4a is removed over the region overlapping the lower electrode 3c and the upper electrode 6d of the storage capacitor 1h in plan view in a depthwise direction, thereby forming the opening 41. For this reason, the dielectric layer 4c of the storage capacitor 1h is formed from a thin portion (upper gate insulating layer 4b) of the gate insulating layer 4. Moreover, an insulating film having the same thickness as the gate insulating layer 4 (upper and lower gate insulating layers 4a, 4b) is formed on the lower electrode 3c along the edge of the lower electrode 3c, and the dielectric layer 4c is surrounded by the thick insulating film. Other parts are the same as those in the first embodiment, and thus the descriptions thereof will be omitted.

The element substrate 10 having the above-described configuration can be basically manufactured by the same method as the first embodiment. That is, at the gate electrode forming step shown in Fig. 4A, the capacitor line is not formed, and the gate line 3a is formed in a planar shape shown in Fig. 12A. Further, at the source/drain electrode forming step shown in Fig. 4G, when the source line 6a and the drain electrode 6b are formed, the upper electrode 6d is formed. In addition, at the planarizing film forming step shown in Fig. 5B, a planarizing film 9 including contact holes 91 and 92 as well as contact holes 81 and 82 is formed. Then, at the contact hole forming step shown in Fig. 5C, when etching is performed on the passivation film 8 using a photolithography technology, contact holes 81 and 82 are formed at positions overlapping the contact holes 91 and 92.

### Other Embodiments

In the above-described embodiments, the lower gate insulating layer 4a and the upper gate insulating layer 4b constituting the gate insulating layer 4 are formed of the same insulating film. Alternatively, the lower gate insulating layer 4a and the upper gate insulating layer 4b can be formed of different insulating films. In this case, when the gate insulating layer 4 is formed of a silicon oxide film and a silicon nitride film, the upper gate insulating layer 4b that is used as the dielectric layer 4c is preferably formed of a silicon nitride film having a high dielectric constant. Further, in the above-described embodiments, the lower gate insulating layer 4a and the upper gate insulating layer 4b have one insulating film. Alternatively, the lower gate insulating layer 4a and the upper gate insulating layer 4b may have a plurality of insulating films.

In the above-described embodiments, in a case where the portion of the gate insulating layer 4 that is partially reduced in thickness is used as the dielectric layer 4c of the storage capacitor 1h. the lower gate insulating layer 4a is removed according to the region inside the periphery of the lower electrode 3c, thereby forming the opening 41. Alternatively, when a decrease in withstand voltage at the edge of the lower electrode 3c or the edge of the upper electrode does not matter or when another countermeasure is carried out, the lower gate insulating layer 4a may be removed over a region wider than the lower electrode 3c or the upper electrode.

In the above-described embodiments, a multilayer film of an aluminum alloy film and a molybdenum film is used as the gate line 3a, and a multilayer film of an aluminum film and a molybdenum film is used as the source line 6a, but other metal films may be used as these wiring lines. Further, a conductive film, such as a silicide film or the like, may be used. In addition, in the above-described embodiments, an intrinsic amorphous silicon film is used as the semiconductor layer 7a, but other silicon films or transparent semiconductor films, such as organic semiconductor films or zinc oxide, may be used.

In the above-described embodiments, a transmissive liquid crystal device has been exemplified, but the invention can be applied to a transflective liquid crystal device or a total reflective liquid crystal device. Further, in the above-described embodiments, a TN mode, an ECB mode, a VAN mode active matrix liquid crystal device has been exemplified, but other modes, such as an IPS (In-Plane Switching) mode and the like, can be applied to the liquid crystal device (electro-optical device) of the invention.

The electro-optical device is not limited to the liquid crystal device. For example, in an organic EL (electroluminescent) device, in each pixel region on an element substrate that holds an organic EL film as an electro-optical material, a thin-film transistor, a pixel electrode electrically connected to the thin-film transistor, and a storage capacitor having a lower electrode below a gate insulating layer of the thin-film transistor are formed. Accordingly the invention can be applied to the organic EL device.

### Embodiment of Electronic Apparatus

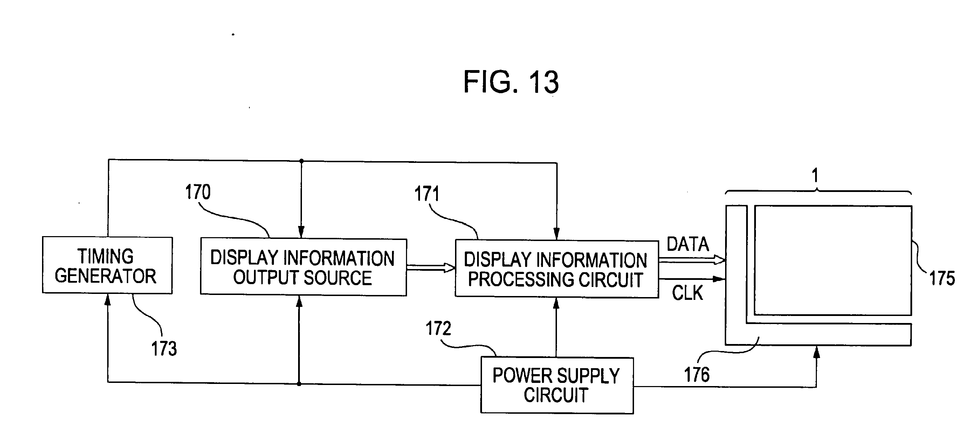

Fig. 13 shows an embodiment when the liquid crystal device according to an embodiment of the invention is used as display devices of various electronic apparatuses. The electronic apparatus used herein is a personal computer or a cellular phone, and has a display information output source 170, a display information processing circuit 171, a power supply circuit 172, a timing generator 173, and a liquid crystal device 1. Further, the liquid crystal device 1 has a panel 175 and a driving circuit 176. As the liquid crystal device 1, the above-described liquid crystal device 1 can be used. The display information output source 170 includes a memory, such as a ROM (Read Only Memory) or RAM (Random Access Memory), a storage unit, such as various disks, and a tuning circuit that synchronously outputs digital image signals. The display information output source 170 supplies display information, such as an image signal having a predetermined format, to the display information processing circuit 171 on the basis of various clock signals generated by the timing generator 173. The display information processing circuit 171 includes various known circuits, such as a serial-to-parallel conversion circuit, an amplification/inversion circuit, a rotation circuit, a gamma correction circuit, and a clamping circuit. The display information processing circuit 171 processes the input display information, and supplies the image signal to the driving circuit 176 together with the clock signal CLK. The power supply circuit 172 supplies a predetermined voltage to various constituent elements.The foregoing description has been given by way of example only and it will be appreciated by a person skilled in the art that modifications can be made without departing from the scope of the present invention.

As an example, although the etching stopping layer 7x is only discussed in connection with one embodiment, it will be clear to those skilled in the art that such an etching stopping layer can also be used in other embodiments.

## Claims

1. An electro-optical device comprising:
a thin-film transistor that has a gate electrode, a gate insulating layer, and a semiconductor layer laminated in each of a plurality of pixel regions on an element substrate;
a pixel electrode that is electrically connected to the thin-film transistor; and
a storage capacitor that has a lower electrode and an upper electrode facing each other with the gate insulating layer interposed therebetween,
wherein, in the thin-film transistor, the gate electrode, the .gate insulating layer, and the semiconductor layer are laminated sequentially in that order,
the gate insulating layer includes a lower gate insulating layer having one or a plurality of insulating films, and an upper gate insulating layer having one or a plurality of insulating films, and
a portion of the lower gate insulating layer where the lower electrode and the upper electrode overlap each other is removed.

2. An electro-optical device according to Claim 1, wherein the lower gate insulating layer is formed to have a thickness sufficient to reduce parasitic capacitance of the thin-film transistor.

3. The electro-optical device according to Claim 1 or Claim 2,
wherein the upper gate insulating film is formed to have a thickness smaller than the lower gate insulating film.

4. The electro-optical device according to any one of the preceding Claims,
wherein the lower gate insulating layer has one insulating film, and the upper gate insulating layer has one insulating film.

5. The electro-optical device according to any one of the preceding Claims,
wherein the semiconductor layer is formed of an amorphous silicon film.

6. The electro-optical device according to any one of the preceding Claims,
wherein the upper gate insulating layer is formed of a silicon nitride film.

7. The electro-optical device according to any one of the preceding Claims,
wherein the upper electrode comprises a portion that extends from a drain electrode of the thin-film transistor to a region facing the lower electrode.

8. The electro-optical device according to any one of the preceding Claims,
wherein the upper electrode is a transparent electrode that is electrically connected to a drain electrode of the thin-film transistor.

9. The electro-optical device according to any one of the preceding Claims,
wherein the upper electrode comprises a portion of the pixel electrode that faces the lower electrode.

10. An electronic apparatus comprising an electro-optical device according to any one of the preceding Claims.

11. A method of manufacturing an electro-optical device that includes a thin-film transistor having a gate electrode, a gate insulating layer, and a semiconductor layer laminated in each of a plurality of pixel regions on an element substrate, a pixel electrode electrically connected to the thin-film transistor, and a storage capacitor having a lower electrode and an upper electrode facing each other with the gate insulating layer interposed therebetween, the method comprising:
forming the gate electrode and the lower electrode together;
forming the gate insulating layer; and
forming the semiconductor layer,
wherein the forming of the gate insulating layer includes forming one or a plurality of insulating films forming a lower layer of the gate insulating layer, removing a portion of the insulating film, which overlaps the lower electrode, formed in the forming of the lower gate insulating layer, and forming one or a plurality of insulating films forming an upper layer of the gate insulating layer.

12. A method according to Claim 11, wherein the lower layer of the gate insulating film is formed to have a thickness sufficient to reduce parasitic capacitance of the thin-film transistor.

13. The method according to Claim 11 or Claim 12,
wherein the forming of the upper gate insulating layer and the forming of the semiconductor layer are successively performed in a state where the element substrate is kept under a vacuum atmosphere.
